# EUROPÄISCHE PATENTANMELDUNG

(11) **EP 4 472 374 A2**
(43) Veröffentlichungstag der Anmeldung: **04.12.2024**
(21) Anmeldenummer: 24205483.1
(22) Anmeldetag: 04.04.2023
(51) Int. Cl.: H05K 7/20

(54) **NACHRÜSTBARER MULTIFUNKTIONALER DISPLAYBAUSTEIN**

(30) Priorität: 06.04.2022 DE 102022108229
(62) Teilanmeldung aus: 23723118.8
(71) Anmelder: Pechmann, Ralph, 03051 Cottbus (DE)
(72) Erfinder: Pechmann, Ralph, 03051 Cottbus (DE)
(74) Vertreter: Haschick, Gerald

(57) **Zusammenfassung**

Verfahren zur Temperaturregelung eines nachrüstbaren multifunktionalen Displaybausteins, welcher zum Nachrüsten in Türen, Wänden, Schränken gegeben ist, wobei die Temperatur innerhalb des Displaybausteins gemessen wird, und eine temperaturabhängige Lüfterregelung stattfindet, wobei im oberen Bereich des Chassis 20 Temperatursensoren 7 die Innentemperatur des Displaybausteins messen und eine Lüftersteuerung die Lüfter 14 in fünf Stufen regelt, wobei in Stufe 1 bei einer Temperatur bis 40 Grad Celsius nur zwei Lüfter 14 mit der halben Drehzahl betrieben werden, in Stufe 2 werden bei einer Temperatur über 40 Grad Celsius vier Lüfter 14 mit der halben Drehzahl betrieben, in Stufe 3 werden bei einer Temperatur über 50 Grad Celsius vier Lüfter mit voller Drehzahl betrieben, in Stufe 4 werden bei einer Temperatur über 54 Grad Celsius vier Lüfter 14 mit voller Drehzahl betrieben und die LED-Hinterleuchtung elektronisch abgeschaltet, sinkt die Temperatur um ca. 5 Grad Celsius, wird die LED-Hinterleuchtung wieder zugeschaltet und in Stufe 5 wird bei einer Temperatur über 60 Grad Celsius das gesamte System notabgeschaltet und nach Temperaturabsenkung unter 60 Grad Celsius wieder angeschaltet, wobei ein Reboot erfolgt, die CMS automatisch gestartet und die Netzwerkverbindung wieder hergestellt wird.

## Beschreibung

Die Erfindung betrifft einen nachrüstbaren multifunktionalen Displaybaustein für sämtliche Nachrüstungen von Türen, Wänden, Schränken und anderen geraden Flächen, welche mit diesem Produkt erweitert werden sollen.

Aus dem Stand der Technik ist US 2015/0250067 bekannt.

Eine Anzeigegehäuseanordnung umfasst einen Schrank, der einen Innenraum umschließt, wobei der Schrank eine Vorderwand und eine Rückwand umfasst, ein oder mehrere Anzeigemodule, die zumindest teilweise im Innenraum eingeschlossen sind, ein oder mehrere Anzeigemodule, die so eingerichtet sind, dass sie eine elektronische Anzeige an der Vorderwand bilden, einen oder mehrere an der Rückwand montierte Ventilatoren, Jeder der einen oder die mehreren Ventilatoren umfasst einen von der Rückwand nach hinten gerichteten Lüftereinlass und einen in den Innenraum gerichteten Lüfterablass, wobei sich eine Lüftungsöffnung zumindest teilweise zwischen der Vorderwand und der Rückwand erstreckt, wobei die Lüftungsöffnung einen ersten Weg für die Kühlung der Luft bietet, um von einer Vorderseite des Gehäuses zur Bereichsseite des Gehäuses zu gelangen. und ein Auslass, der einen zweiten Weg für erwärmte Luft bietet, um den Innenraum zu verlassen.

Die Displays können an der Vorder- oder und Rückwand der Schränke montiert werden.

Des Weiteren ist US 2016/0192536 bekannt.

Eine elektronische Anzeigeanordnung zum Aufhängen einer elektronischen Anzeige an einem oder mehreren länglichen Stäben ist offenbart. Ein geschlossener Kreislauf zirkulierender Flüssigkeit, wie z. B. Luft, kann in einem versiegelten Elektronikraum angeordnet sein. Ein offener Schleifenkanal kann es Flüssigkeiten, wie z. B. Umgebungsluft, ermöglichen, durch die Baugruppe über einen Kanal zu strömen, der durch den Raum zwischen der hinteren Wanne und der elektronischen Anzeige definiert ist. Ein Paar Durchgänge erstrecken sich vorzugsweise vertikal entlang der Baugruppe und sind so konfiguriert, dass sie den Durchgang eines länglichen Elements aufnehmen. Innerhalb dieser Durchgänge können Klemmen verwendet werden, um die Baugruppe an den länglichen Elementen zu befestigen.

Aufgabe der Erfindung ist es, einen nachrüstbaren multifunktionalen Displaybaustein zu entwickeln, welcher aufgrund des geringen Gewichtes und eines inneren autarken Aufbaus, abgesehen von der Netzeinspeisung, überall nachgerüstet werden kann.

Die Aufgabe der Erfindung wird dadurch gelöst, dass ein nachrüstbarer multifunktionaler Displaybaustein gemäß Anspruch 1 und der nachfolgenden Beschreibung entwickelt wurde.

Anordnung des multifunktionalen Displaybausteins zur Führung des Luftstroms innerhalb des Displaybausteins, wobei unterhalb Radiallüfter 14 gegeben sind, und nachfolgend der Luftstrom 25 über ein Chassis 20, welches mittig im Displaybaustein angeordnet ist, geteilt wird, und oberhalb des Displaybausteins durch ein Luftleitblech 26, welches nach innen ausgerichtet an der Rückwand 18 im oberen Drittel unten befestigt ist, wieder zusammengeführt wird und durch die Luftaustrittsöffnungen 6 austritt.

Der nachrüstbare multifunktionale Displaybaustein, im Folgenden Displaybaustein genannt, wurde so konzipiert, dass durch sein geringes Gewicht und der eigenen Lüftung eine autarke Anwendung, abgesehen von der Zuführung der Netzspannung, stattfindet. Für Änderungen der AD-Inhalte ist es ebenfalls erforderlich, den Displaybaustein eine Internetverbindung zur Verfügung zu stellen. Dies kann kabelgebunden (LAN), mittels LTE oder WLAN erfolgen. Es ist somit möglich bei Einbau bzw. Nachrüstung des Displaybausteins sämtliche multimedialen Aktivitäten über das Display ablaufen zu lassen, z.B. Werbung, Filme, Bilder, Inhalte direkt aus dem Internet, Informationen.

Wichtige Voraussetzung für den Einsatz des Displaybausteins ist, dass die statische Sicherheit im Einbauort gegeben ist, was sich aber durch das geringe Gewicht der erfinderischen Lösung in den meisten Fällen als unproblematisch darstellt.

Der Displaybaustein ist also dort anwendbar, wo eine separate Stromeinspeisung möglich ist welche den Displaybaustein versorgt bzw. wo auch aus lüftungstechnischer Sicht eine Anwendung möglich ist. Insbesondere ist der Displaybaustein für den Türeinbau in Schränken, in Schrankwänden von Schränken oder auch für Wände, welche rückseitig zugänglich sind.

Der Erfindungsschwerpunkt liegt darin begründet, dass ein Konzept entwickelt wurde, durch das die Anwendung des Displaybausteins für an sich bekannte Multifunktionsgehäuse ausgeführt wurde, wobei der Einbau in der jeweiligen Tür des Multifunktionsgehäuses stattfindet.

Das Multifunktionsgehäuse ist ein doppelwandiges SiCab Außengehäuse und bietet optimale Einbau- und Klimabedingungen für elektronische Baugruppen, wobei diese vor Witterungseinflüssen geschützt werden sowie Beschädigungen nahezu ausgeschlossen sind.

Das modular aufgebaute Gehäuse besteht aus einem Aluminiumprofilrahmen, Innengehäuse, und einer angesetzten Kunststoffaußenhülle aus Polycarbonat.

Im Dachmodul können aktive Klimakomponenten eingebaut werden.

Bei dem erfinderischen Produkt handelt es sich um einen outdoorfähigen, nachrüstbaren, multifunktionalen Displaybaustein, welcher für den Einbau in Multifunktionsgehäuse konzipiert ist, welche die Bauart SiCab 8, 12, 15, 18 und 24 aufweisen. Ein Einbau in andere Gehäuse, Wände, Schränke und Türen ist ebenfalls möglich.

Auf diesem können verschiedene Inhalte im 16:9 Hochkant-Format (Portraitmodus) wiedergegeben werden. Dabei ist es unerheblich, ob es sich um fixe Bilder oder bewegte Videos, kombinierte Inhalte aus Bild und Video oder Onlineinhalte direkt aus dem Internet handelt.

Die Bildinhalte werden von einem integrierten Player erzeugt und an das LCD-Panel weitergegeben.

Empfangen und verwaltet werden die Inhalte auf dem Player, mittels einer CMS-Software, die mit verschiedenen Betriebssystemen arbeiten kann. Angesteuert wird die Software mittels WLAN, Mobilfunk, LAN oder USB. Damit ist ein ortsunabhängiger Zugriff auf die Inhalte und Hardware möglich. Für den Fall eines Netzwerkausfalles, laufen die zuletzt eingespielten Inhalte so lange weiter, bis das Netzwerk (Internet) wieder hergestellt wurde. Damit ist gewährleistet, dass es zu keinem Verlust der Inhalte kommt. Um dies zu erreichen, werden die Inhalte in dem Displaybaustein vor Ort zwischengespeichert.

Das Display selbst und alle Komponenten befinden sich in einem pulverbeschichteten Rahmen aus Aluminium.

Geschützt werden diese gegen Vandalismus und Sonneneinstrahlung durch eine VSG-Frontscheibe, die fest mit dem Rahmen verklebt ist. Die Frontscheibe ist chemisch entspiegelt und besteht aus zwei Schichten Floatglas, die miteinander mittels VSG-S Folie Solar-Protect verklebt sind.

Ein Helligkeitssensor an der unteren Seite des Rahmens ermittelt die Umgebungshelligkeit und regelt die Displayintensität. Somit kann auch in der Nacht gewährleistet werden, dass es zu keiner Blendung oder Störungen im öffentlichen Raum durch überhöhte Helligkeit kommt. Durch die Wahl an der unteren Seite, wird die Gefahr einer Verschmutzung, Manipulation oder Vandalismus stark verringert und die Betriebssicherheit dadurch erhöht.

Versorgt wird das Display mit Wechsel- oder Gleichstrom (je nach Anforderungen), welcher von einem Anschluss im Multifunktionsgehäuse bereitgestellt wird. Die Wechselspannung kann hierbei zwischen 100 bis 230 Volt und die Gleichspannung ab 24 Volt liegen.

Das Display ist für den Dauereinsatz konzipiert und verfügt über eine eigene aktive Kühlung mittels mehrerer Radiallüfter im unteren Gehäusebereich. Dies gewährleistet das Ansaugen kühler Luft aus dem erdnahen Bereich sowie einen sehr hohen Luftdurchsatz zur Kühlung der Komponenten. Aufgrund dieses Kühlkonzeptes und der Wahl des Einbauortes des Displaybausteins, werden die dahinterliegenden Baugruppen des Schrankes nicht negativ beeinflusst. Der Displaybaustein wird außerhalb des IP-Bereiches des Multifunktionsgehäuses eingebaut. Somit wird das Klima im Schrankinneren nicht beeinflusst. Auch dies wurde im Klimakammertest nachgewiesen.

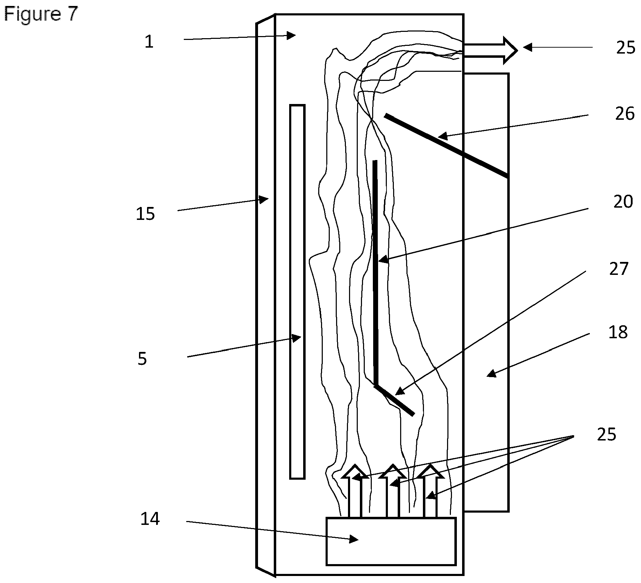

Durch die Verwendung und den konzeptionellen Aufbau der Radiallüfter, ist der Luftstrom sehr effizient. Durch Luftleitbleche im Inneren, kann der Luftstrom zusätzlich gezielt an die zu kühlenden Bereiche geleitet werden. Dieses Alleinstellungsmerkmal wurde durch viele Computersimulationen entwickelt und immer wieder verfeinert bzw. angepasst. Ein Test in der Klimakammer eines unabhängigen Labors, hat dann die Simulationen bestätigt. Figur 7 stellt im seitlichen Querschnitt des Displaybausteins den Luftstrom grafisch dar.

Das Display ist während seiner Entwicklung verschiedene Entwicklungsstufen und Tests durchlaufen. Die Konstruktion wurde nach jedem Test angepasst und erneut getestet. Sie erfüllt alle Kriterien der Betriebssicherheit im Outdoorbereich, insbesondere für öffentliche Straßen, Wege und Plätze.

Um eine optimale Innenraumtemperatur zu schaffen, wurden mehrfach die Luftströmungsverhältnisse angepasst.

Dies ist durch Schließung von Luftbypässen und falsch positionierten Luftschlitzen in dem Displaybaustein sowie Veränderung der Lüfter-Bauart und Einbringung von Luftleitblechen gelungen. Durch die Anordnung der Lüfter im unteren Bereich, kann aus dem erdnahen Bereich kühle Luft angesaugt werden und wird dann nach oben durch das System geleitet an den zu kühlenden Flächen geleitet.

Ein weiterer wichtiger Faktor war eine Reduzierung und Veränderung der Position / Lage von Baugruppen. Durch eine offenere Bauform der einzelnen Module wird der Luftstrom so wenig wie möglich behindert. Des Weiteren wurden Kabelwege optimiert, um einen möglichst geringen Luftwiderstand zu erhalten. Die Kabelführungen sind, sofern es möglich ist, längs in Richtung des Luftstromes verlegt.

Die Lüfter Steuerung erfolgt in mehreren Stufen. Sie dient der optimalen Kühlung des Systems und der Reduzierung von Lüfter Geräuschen. Durch die Reduzierung der Lüfter Geräusche, ist nun auch möglich das Display an beruhigten Zonen im öffentlichen Raum eizusetzen. Durch Temperatursensoren, welche sich an kritischen Stellen befinden, werden die Lüfter in mehreren Stufen geregelt. Laut der Computersimulation ist der Wärmehotspot im oberen Bereich des Displaybausteins. An dieser Stelle befinden sich auch diese Sensoren.

Die Lüftersteuerung erfolgt in fünf Stufen:
Stufe 1 (<40°C):
   - 2 von 4 Lüftern werden mit halber Drehzahl betrieben.
   - Dadurch wird bei niedrigen Temperaturen der Geräuschpegel auf ein Minimum abgesenkt, die Kühlung der aktiven Bauelemente gewährleistet, für dauerhafte Luftumwälzung gesorgt und damit eine Bildung von Kondenswasser bei niedrigen Temperaturen vermieden.
Stufe 2 (40°C):
   - 4 von 4 Lüftern werden mit halber Drehzahl betrieben.
   - Bei ansteigender Temperatur erhöhen wir den Luftstrom und eine ausreichende Kühlung kann gewährleistet werden. Durch die weiterhin reduzierte Drehzahl wird der Geräuschpegel auf ein Minimum reduziert.
Stufe 3 (50°C):
   - steigt die Temperatur weiter an, werden beide Lüfterpaare auf volle Drehzahl angehoben.
Stufe 4 (54°C):
   - steigt die Temperatur weiter, wird der Hauptverbraucher elektronisch abgeschaltet. Der Hauptverbraucher ist die LED-Hinterleuchtung mit ca. 100-120 Watt.
   - Aufgrund der geringeren Leistungsaufnahme durch die Abschaltung und damit geringeren Wärmeabgabe, kann sich das System abkühlen.
   - Während dieser Abschaltung laufen beide Lüfterpaare auf voller Drehzahl und gewähren somit maximalen Luftstrom.
   - Wenn die Temperatur um ca. 5°C gesunken ist, wird der Hauptverbraucher wieder eingeschaltet.
   - In der Zeit der Abschaltung des Hauptverbrauchers laufen alle anderen Baugruppen normal weiter.
   - Dies verkürzt die Ausfallzeiten für die Widergabe der Inhalte aber schützt das System vor zu hohen Temperaturen.
Stufe 5 (>60°C):
   - Steigt die Temperatur außerhalb der Spezifikation, wird das System notabgeschaltet.
   - Die Notabschaltung trennt alle Komponenten von der Stromversorgung ab. Die Komponenten sind in dieser Zeit stromlos.
   - Sinkt die Temperatur wieder innerhalb der Spezifikation, schaltet sich das System automatisch wieder ein.
   - Anschließend erfolgt ein Reboot und die CMS startet automatisch. Die Netzwerkverbindung wird hergestellt.
   - Alle Inhalte werden wieder normal angezeigt.

Die gesamte Technik des Netzbetreibers sowie die Mechanik des Schrankes selbst werden durch das Display nicht negativ beeinflusst. Dies wurde durch Test am Computer und in der Klimakammer sowie den Nachweis der Widerstandfähigkeit eines unabhängigen Prüflabors nachgewiesen.

Gegen Regen, intensive Sonneneinstrahlung und Vandalismus ist das Gerät geschützt.

Durch verschiedene Schutzmaßnahmen ist das Gerät für Passanten und Servicemitarbeiter berührungssicher und ungefährlich.

Die Erfindung wird nun an einem Ausführungsbeispiel mit den Figuren näher erläutert.

Dafür sind
Figur 1, Innenansicht der Funktionselemente des Displaybausteins,
Figur 2, Blockschaltbild,
Figur 3, Einbauart des Displaybausteins,
Figur 4, Frontansicht,
Figur 5, Rückansicht und Darstellung des Luftstromes durch den gesamten Displaybaustein,
Figur 6, Rückwand mit Darstellung der Luftleitbleche,
Figur 7, Seitenansicht mit Darstellung des Luftstromes und der innenliegenden Luftleitbleche.

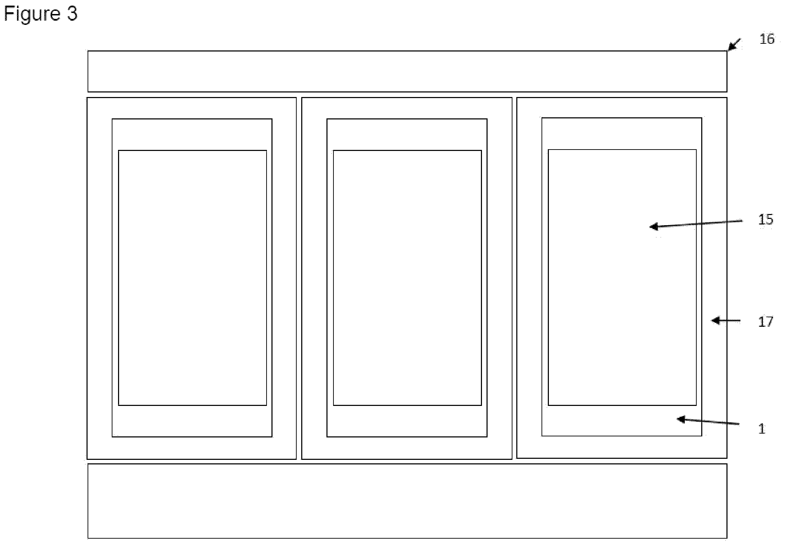

Figur 3 zeigt eine Einbauart des Displaybausteins, dahin gegeben das ein Multifunktionsgehäuse 16 beispielhafterweise mit drei Türen 17 versehen ist.

In den Rahmen 1 der Tür 17 ist die VSG-Scheibe 15 mit dahinter liegendem LCD-Panel 5 eingesetzt.

Eingebaut wird das Display in eine Standardtür des Multifunktionsgehäuses 16.

Es werden Standardtüren 17 mit den Maßen 100cm, 70cm und 60cm verwendet. Der Rahmen wird mittig in die Tür eingesetzt, fest verbunden und abgedichtet.

Das Multifunktionsgehäuse 16, die Türen 17 und der Rahmen 1 des Displaybausteins, haben RAL-Farbe 7038.

### Konformität und Sicherheit

| | |
|---|---|
| Schutzart IP: | IP55 (der Bestimmung eingesetzt und eingebaut im Multifunktionsgehäuse und im geschlossenen Zustand) DIN EN 60529 (VDE0470-1) DIN EN60529 Prüfbericht P50-22-0265 vom 14.-18.07.2022 |
| Schutzklasse Elektro: | Schutzklasse 1 DIN EN 61140(VDE 0140-1) |
| Scheibe: | VSG-Frontscheibe 2x2mm mit VSG-S Folie (Sicherheitsverbundglas mit UV- und IR-Filter sowie chemisch entspiegelt) Verbundsicherheitsglas nach DIN EN 12543 - Ballwurfsicher nach DIN 18032-3 - Schlagfest nach DIN EN 50102 |
| Temperatur: | automatische Temperaturüberwachung |
| Widerstandsfähigkeit gegen manuelle Einbruchsversuche: | Prüfbericht 2622015-02 vom 04.03.022, Widerstandsklasse RC2 |
| | Geprüft durch EPH, 01217 Dresden |
| Klimatest: | DIN EN60068-2-5 Prüfbericht P50-22-0206 vom 23.06.2022 |
| Prüfung Schocken: | DIN EN 60068-2-27 (Ausgabe 2010-02) Prüfbericht P50-22-0286 vom 12.08.2022 |
| Prüfung Salznebel: | DIN EN 60068-2-11 (Ausgabe 2000-02) Prüfbericht P50-22-0286 vom 12.08.2023 |
| Prüfung Kälte: | DIN EN 60068-2-1 (Ausgabe 2008-01) Prüfbericht P50-22-0286 vom 12.08.2022 |
| Prüfung EMV (Class B): | laut Prüfbericht PB EMV 140223-1 und PB EMV 070323-1 |
| | DELTA IDL GmbH 4474 vom 14.02.2023 |
| Gerätesicherheit: | DIN EN IEC 62368-1:2020+A11:2020 Prüfbericht PB_GS_2023-03-01_PA4475 |
| 2011/65/EU | RoHS |
| 2014 /53/EU | RED |

### Technische Daten:

Outdoor Displaymodul
Gehäuse
Front: Alublech, pulverbeschichtet (RAL7038), outdoorfähig, Korrosivitätsklasse C3
Panelabdeckung + Filterhalter: Alublech, pulverbeschichtet (RAL7038), outdoorfähig
VSG-Frontscheibe 2x2mm chemisch entspiegeltes Floatglas mit VSG-S Folie Solar Protect Folie verklebt zwischen den Scheiben (Infrarot absorbierend und reflektierend), Lüfter
(Luftansaugung und Luftabgabe über Schaltkastengehäuse)

### Display

| | |
|---|---|
| Diagonale: | 32" |
| Resolution: | 1920 x 1080 |
| Aspect Ratio: | 16:9 |
| Brightness: | 2000 - 3000 cd/m2 |
| Contrast Ratio: | 1200:1 |
| Color support: | 8 Bit (16,7M) |
| Response time: | 9 ms |
| Viewing Angle: | 178° / 178° |
| Operating time: | 24/7 |
| Orientation: | Portrait |
| Lifetime: | 50.000 h |

Helligkeitssteuerung durch Umgebungslichtsensor

### Player

Verschiedene Modelle je nach Kunde und Anwendung
Abmessungen und Gewicht Gehäuse

| | |
|---|---|
| Abmessungen: | BxHxT = ca. 487mm x 887mm x 67mm |
| Gewicht: | ca. 15kg |

### Anschlussdaten

| | |
|---|---|
| Anschlussdaten: | 100-240V/50Hz/60Hz Variante Versorgung mit Wechselspannung |
| Stromverbrauch: | ca. 140 Watt |

### Umgebungsbedingungen

| | |
|---|---|
| Schutzklasse: | IP55 |
| Temperatur: | -20°C bis +40°C |
| Luftfeuchtigkeit: | 0-95% |

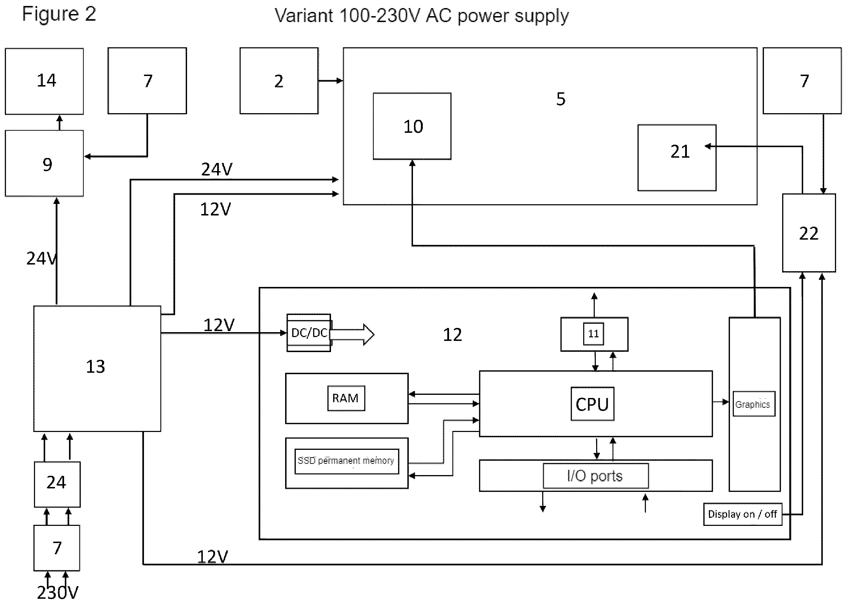

Elektrische Beschreibung für Aufbau 100VAC-230VAC-Version ist im Blockschaltplan Figur 2 dargestellt.

In der Version Versorgung mit Gleichspannung/Gleichstrom, sind die Netzteile sogenannte DC/DC Wandler, aber auch mit der Funktion, die Eingangsspannung in die benötigten Ausgangsspannungen umzuwandeln.

### Netzteil 13:

Das Netzteil 13 wird mit 100-240V AC (Wechselspannung) versorgt. Das Netzteil 13 hat nun die Aufgabe, alle Komponenten des Gesamtsystems mit einer stabilisierten Gleichspannung zu versorgen. Zur Verfügung werden +12V und +24V gestellt. Weiterhin ist das Netzteil 13 durch interne Schutzschaltungen gegen Überstrom und Kurzschluss gesichert.

Der Arbeitstemperaturbereich liegt von 0-50°C. Die Umgebungsluftfeuchte darf von 30-85% betragen.

### LCD-Unit:

Zu den Komponenten der LCD-Unit gehören das LCD-Panel 5 mit integrierter Hinterleuchtung auf LED-Basis, das T-Con Modul 10, LED-Controller 21 und Umgebungshelligkeitssensor 2.

Die Bildsignale werden über den "LVDS" Standard (51polig, 2Kanal, 8Bit) am T-Con Modul 10 zugeführt. Dieses Modul stellt dann die digitalen Signale für die Ansteuermatrix des LCD's zur Verfügung. Das T-Con Modul 10 arbeitet hierbei mit +12V.

Zur Ansteuerung und Regelung der LED's, befindet sich auf dem Display ein LED-Controller 21. Dieses wird mit +24V versorgt.

Seine Aufgabe ist es, die Ströme für die Leuchtdioden zur Verfügung zu stellen und eine Helligkeitsreglung entsprechend der Umgebungshelligkeit zu realisieren.

Der Helligkeitsregelbereich im Dimmingbetrieb liegt von 30-100%. Eine Steuerspannung welche vom Player / Computer kommt, ist in der Lage die Hinterleuchtung ein- oder auszuschalten (0V = off, >2,5V = on Typ 3,3V).

Die maximale Arbeitstemperatur der LCD-Unit liegt auf der Rückseite bei +50°C und auf der Front bei +68°C. Die Umgebungsluftfeuchte darf zwischen 30-85% liegen.

### Player / Computer 12:

Zum Einsatz kommt hier eine Industriecomputerplatine. Sie ist mit CPU, RAM, und SSD-Festspeicher bestückt. Auf dieser Platine können verschiedene Betriebssysteme installiert werden, so zum Beispiel Windows, Linux, etc. Die Bildsignale können via HDMI oder LVDS ausgegeben werden. Als IO-Ports stehen verschiedene Möglichkeiten zur Verfügung.

Ein zusätzliches LTE oder WLAN-Modul 11 mit abgesetzter und nach außen geführter Antenne kann direkt als Zusatzmodul auf dem Player/ Computer 12 installiert werden. Das LTE-Modul hat ebenfalls eine abgesetzte und nach außen geführter Antenne, die an Stelle der WLAN-Antenne 3 montiert wird.

Als Arbeitsgrundlage dient ein Betriebssystem mit integrierter Treibersoftware zur Hardware, und eine CMS-Software zum Verwalten der AD-Inhalte sowie Steuerung der Hardware.

Je nach eingesetzter CMS-Software (Content Management Systems) stehen dem Endkunden nun verschiedene Möglichkeiten der Bedienung zu Verfügung. Die Inhalte werden hierbei via Funk (WLAN, Mobilfunk) oder über Kabel (LAN, USB) zugeführt und verwaltet. Auch ein Abreißen der Verbindung zum CMS-Server führt nicht zu einem Ausfall der Inhalte, da diese lokal zwischengespeichert werden. Eine direkte Bedienung am Gerät ist nicht vorgesehen, kann aber auf Kundenwunsch eingebaut werden.

Die Versorgungsspannung des Players / Computer kann zwischen +9V- +36V betragen.

Die Arbeitstemperatur liegt bei dieser Platine von 0-+60°C.

Die Umgebungsluftfeuchte darf zwischen 10-90% liegen.

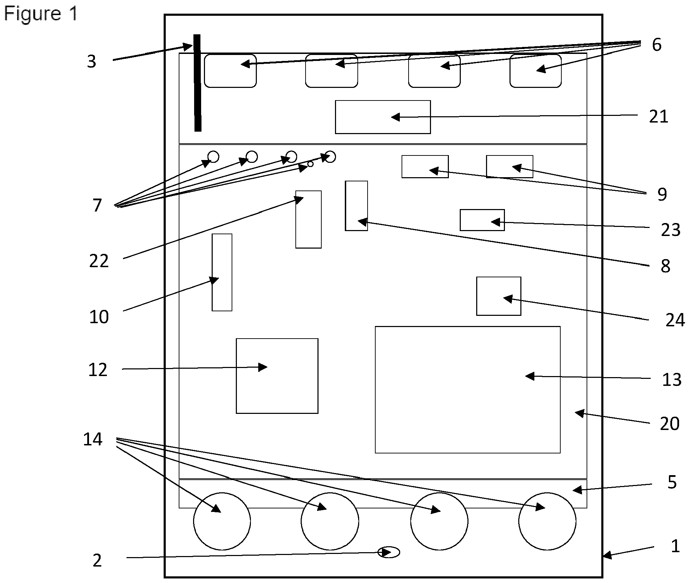

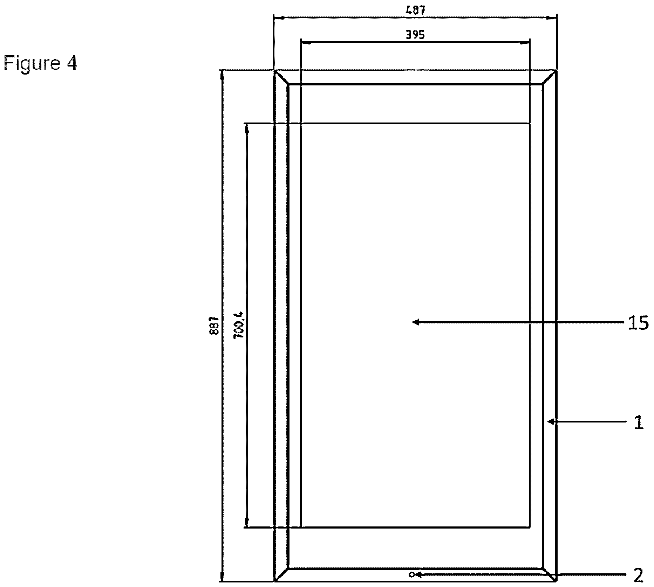

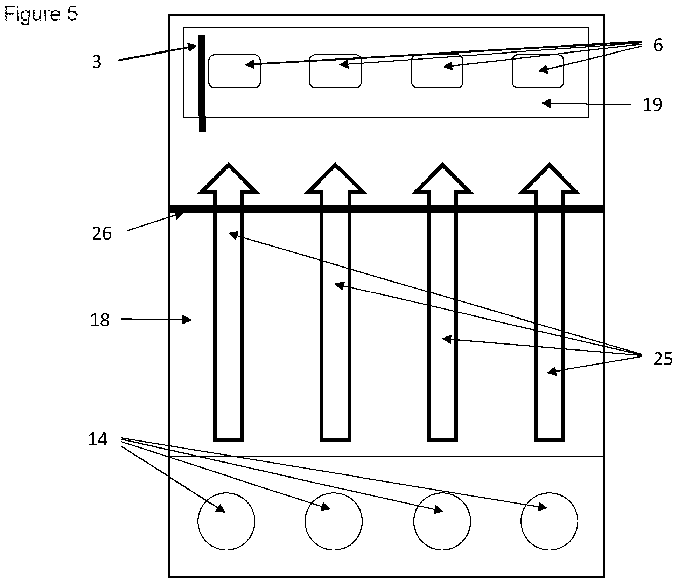

In der Figur 1 ist der Aufbau der einzelnen Funktionselemente des Displaybausteins ersichtlich. Dabei ist auch die Figur 4 zu beachten, welche die Frontansicht des Displaybausteins im Rahmen 1 mit VSG-Scheibe 15 und dem dahinter liegenden LCD-Panel 5 wiedergibt. Die Rückwand 18 in den Figuren 5, 6 und 7 zeigt insbesondere die erfinderische Lösung in der Anordnung der Lüftungsanlage, welche wesentlich dazu beiträgt, dass der Displaybaustein lüftungstechnisch funktional ausgeführt ist.

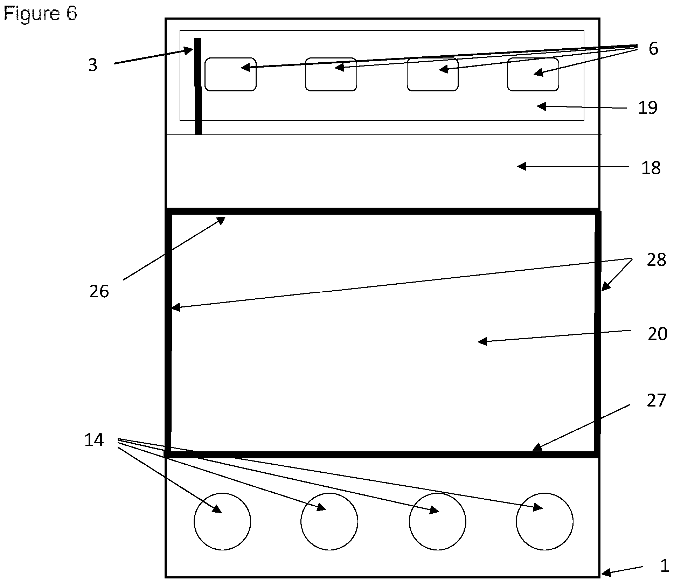

In Figur 5 und 7 ist der Luftstrom zu erkennen und die Einbaulage der Lüfter. In Figur 6 und 7 sind die Luftleitbleche 26, 27 ,28 ersichtlich.

In Figur 4 sind die Abmessungen des Displaybausteins von 487 x 887 mm sowie der VSG-Scheibe 15 mit dahinterliegendem LCD-Panel 5 von 395 x 700,4 mm dargestellt.

Dabei zeigt die Figur 1 die Innenansicht des Displaybausteins und seine darin enthaltenen Funktionselemente.

Der Displaybaustein besteht insbesondere aus einem Rahmen 1, welcher unterhalb einen Umgebungshelligkeitssensor 2 nach vorne hin aufweist. Des Weiteren sind unterhalb die vier Radiallüfter 14 gegeben. Nach oben hin schließt sich das LCD-Panel 5 an.

Auf dem Chassis 20 sind die einzelnen Bauelemente wie Lüftersteuerung 9, Stromanschluss/Verteiler 24V 8, Stromanschluss/Verteiler Versorgungsspannung 23, Temperaturschalter 22, Netzeingangsfilter bei Versorgung mit 100-230V Wechselspannung 24, Player/Computerplatine 12, T-Con Modul 10 und Netzteil/Stromversorgung 13 integriert.

Im oberen Bereich des Chassis 20 sind fünf Temperatursensoren 7 gegeben. Die Temperatursensoren 7 dienen dazu, die Innentemperatur des Displaybausteins zu überwachen und die Lüftung in der Intensität zu regeln und dahingehend zu steuern, dass Baugruppenabschaltungen vorgenommen werden, sowie im Übertemperaturbereich das Gerät vollständig von der Versorgungsspannung getrennt wird.

Weiterhin sind oberhalb des Chassis ein LED-Controller 21 als Bestandteil des LCD-Panels 5, die Antenne für WLAN oder LTE 3 und die Luftaustrittsöffnungen 6 gegeben.

Wichtig ist dabei zu erwähnen, dass die Radiallüfter 14, die Luftaustrittsöffnungen 6 sowie die WLAN- oder LTE-Antenne 3 nur in der Rückwand 18 des Displaybausteins vorhanden sind.

Die Rückwand 18 des Displaybausteins wird zeichnerisch nochmals in der Figur 5 dargestellt. Die Figur 5 zeigt die Rückwand 18 des Displaybausteins, wobei in der Rückwand 18 im unteren Bereich vier Radiallüfter 14 installiert sind und im oberen Bereich vier Luftaustrittsöffnungen 6 gegeben sind. Außerdem ist im Bereich der Luftaustrittsöffnungen 6 die WLAN- oder LTE-Antenne 3 vorhanden.

Wichtig ist noch zu erwähnen, dass an der Rückwand 18, etwa am unteren Abschluss des oberen Drittels des Displaybausteins, ein Luftleitblech 26 vorhanden ist. Dieses Luftleitblech 26 ist schräg zum Inneren des Displaybausteins angeordnet und fest verbunden mit der Rückwand 18. Hierbei handelt es sich um ein Luftleitblech, welches über die volle Breite der Rückwand 18, ca. 5 cm groß ist und einen Winkel von 45 Grad zum Inneren des Displaybausteins ausgerichtet ist. Des Weiteren ist der Luftstrom 25 von den Radiallüftern 14 hin zu den Luftaustrittsöffnungen 6 dargestellt.

Nachfolgend werden die Figuren 6 und 7, welche insbesondere den Luftstrom bzw. die Problematik der Luftleitbleche 26, die Abwinkelung unteres Chassis 27 sowie die Seitenbleche Chassis 28 darstellen.

Aus der Figur 6 ist die Rückwand 18 gegeben. Mittig ist das Chassis 20, welches nicht an der Rückwand 18 befestigt ist, dargestellt. Das Chassis 20 weist eine Abwinkelung am unteren Chassis 27 auf, welche ca. 2cm groß ist und in einem Winkel von 45 Grad zur Rückwand 18 angeordnet ist. Des Weiteren ist das Luftleitblech 26, welches an der Rückwand wie schon beschrieben hin zum inneren Bereich des Displaybausteins angeordnet ist.

Wichtig dabei ist, dass zwei Seitenbleche 28 an dem Chassis 20 angeordnet sind, welche verhindern, dass der Luftstrom 25 seitlich an dem Chassis 20 vorbeiführt, sondern oberhalb und unterhalb des Chassis wie aus der Figur 7 ersichtlich geführt wird.

In der Figur 7 ist insbesondere der Luftstrom 25 ersichtlich, welcher von den Radiallüftern 14 hin zu den Luftaustrittsöffnungen 6 stattfindet. Hierbei ist die Anordnung des Chassis 20 mit seiner Abwinkelung unteres Chassis 27 dargestellt. Weiterhin ist die Position des Luftleitbleches 26 an der Rückwand 18 dargestellt. Die Abwinkelung unteres Chassis 27 ist mit 45 Grad angeordnet. Es wird damit eine Luftstromteilung im unteren Bereich im Inneren des Displaybausteins ausgeführt, wobei wichtig ist, dass durch die Abwinkelung unteres Chassis 27 der Luftstrom verstärkt unterhalb des Chassis 20 geführt ist. Das Luftleitblech 26 mit dem Winkel von ca. 45 Grad mit der Rückwand 18 fest verbunden und einer Größe von ca. 5 cm über die volle Breite der Rückwand bringt den Luftstrom 25 im oberen Bereich des Displaybausteins wieder zusammen und führt sie hin zu den Luftaustrittsöffnungen 6.

Im unteren Bereich sind vier Radiallüfter 14 vorhanden, welche für die erfindungsgemäße Luftströmung sorgen.

Für eine gute und ausreichende Lüftung, wurden vier Radiallüfter 14 verbaut. Der Luftstrom wird über integrierte Leitbleche 26, 27 geführt und damit an den wichtigen Stellen vorbeigeleitet. Die Bleche 28 verhindern weiterhin ein seitliches Vorbeiströmen der Luft.

Die Zuführung der kalten Luft erfolgt am unteren Rand des Displaybausteins mittels der vier Radiallüfter 14 und wird nach oben, über die zu kühlenden Bereiche, an die Luftaustrittsöffnungen 6 geleitet.

Damit es zu einem geringeren Schallpegel, bedingt durch das Lüfter Geräusch kommt, sind die Radiallüfter 14 geregelt und geschaltet. Das Absenken der Drehzahl erfolgt über DC/DC-Wandler, die aus +24V ca. +15V erzeugen und damit die Radiallüfter 14 versorgt (Radiallüfter drehen bei ca. 50%). Bei Innentemperaturen unterhalb 40°C ist ein Lüfterpaar außer Betrieb und das andere Lüfterpaar dreht bei ca. 50%. Bei einer Temperaturerhöhung oberhalb 40°C schließt ein Bimetall und versorgt das zweite Lüfterpaar über einen DCDC-Wandler mit Spannung. Auch hier drehen beide Paare noch mit ca.50%. Ab einer Temperatur von 50°C wird die Spannungsabsenkung umgangen und beide Paare drehen mit 100%. Ab 54°C wird die LED-Hinterleuchtung abgeschaltet, die ca. 100-120W beträgt, damit reduziert sich die Wärmeentwicklung und das Gerät kühlt wieder ab. Beide Lüfterpaare drehen zu diesem Zeitpunkt mit 100%.

### Zusätzliche thermische Schutzmaßnahmen

Da es witterungs- und standortbedingt auch zu höheren Umgebungstemperaturen kommen kann, ist eine Übertemperatursicherung mittels Bimetalls eingebaut, die ab einer Obertemperaturgrenze von 60°C am Display die Stromversorgung unterbricht und somit ein Überhitzen des Systems ausgeschlossen werden kann.

Die Bildschirmoberfläche wird durch eine in der VSG-Scheibe integrierten Solar Protect Folie, die infrarotabsorbierend und reflektierend ist, geschützt.

### Vorteile der Erfindung

Der Displaybaustein wurde entwickelt, um in bestehende Multifunktionsgehäuse integriert zu werden.

Da diese Gehäuse in jeder Stadt und fast in jeder Straße zu finden sind, kann auf eine große vorhandene Infrastruktur aufgesetzt werden. Dadurch entfallen teure und aufwendige Bauarbeiten. Des Weiteren kann aufgrund der großen Stückzahl dieser Gehäuse eine breite Masse an Personen erreicht werden.

Eine weitere Besonderheit ist, dass dieses Display nicht nur für Werbezwecke verwendet werden kann, sondern in Ausnahme- und Katstrophenfällen auch Warn- und Evakuierungs-Pläne anzeigen kann. Auch Ereignisse, Wissenswertes zur Umgebung oder touristische Informationen können in Echtzeit übermittelt und angezeigt werden.

Das geringe Gewicht von ca. 15 kg sowie das hocheffiziente Lüftungskonzept für den Displaybaustein ist im Outdoorbereich einzigartig.

Ein weiteres Alleinstellungsmerkmal ist, das die Geräuschemission, die durch Lüftergeräusche entstehen, auf ein Minimum reduziert werden. Dadurch ist unser Displaybaustein auch in z.b. Wohngebieten einsetzbar.

### Bezugszeichen

- 1: Rahmen
- 2: Umgebungshelligkeitssensor
- 3: Antenne WLAN oder LTE
- 4 5: LCD-Panel
- 6: Luftaustrittsöffnungen
- 7: Temperatursensoren
- 8: Stromanschluß / Verteiler 24V
- 9: Lüftersteuerung
- 10: T-Con Modul / Bestandteil des LCD-Panel
- 11: WLAN / LTE Modul Optional auf PC (Mainboard)
- 12: Player/Computerplatine
- 13: Netzteil/Stromversorgung
- 14: Radiallüfter
- 15: VSG-Scheibe mit dahinter liegenden LCD-Panel (5)
- 16: Multifunktionsgehäuse
- 17: Tür
- 18: Rückwand
- 19: abnehmbarer Rahmen
- 20: Chassis
- 21: LED-Controller / Bestandteil des LCD-Panel
- 22: Temperaturschalter
- 23: Stromanschluss / Verteiler Versorgungsspannung
- 24: Netzeingangsfilter bei Versorgung mit 100-230V
- 25: Luftstrom
- 26: Luftleitblech Rückwand
- 27: Abwinkelung unteres Chassis
- 28: Seitenbleche Chassis für Luftstromleitung

## Patentansprüche

1. Verfahren zur Temperaturregelung eines nachrüstbaren multifunktionalen Displaybausteins, welcher zum Nachrüsten in Türen, Wänden, Schränken gegeben ist, wobei die Temperatur innerhalb des Displaybausteins gemessen wird, und eine temperaturabhängige Lüfterregelung stattfindet,
**dadurch gekennzeichnet, dass**
im oberen Bereich des Chassis 20 Temperatursensoren 7 die Innentemperatur des Displaybausteins messen und eine Lüftersteuerung die Lüfter 14 in fünf Stufen regelt, wobei in Stufe 1 bei einer Temperatur bis 40 Grad Celsius nur zwei Lüfter 14 mit der halben Drehzahl betrieben werden, in Stufe 2 werden bei einer Temperatur über 40 Grad Celsius vier Lüfter 14 mit der halben Drehzahl betrieben, in Stufe 3 werden bei einer Temperatur über 50 Grad Celsius vier Lüfter mit voller Drehzahl betrieben, in Stufe 4 werden bei einer Temperatur über 54 Grad Celsius vier Lüfter 14 mit voller Drehzahl betrieben und die LED-Hinterleuchtung elektronisch abgeschaltet, sinkt die Temperatur um ca. 5 Grad Celsius, wird die LED-Hinterleuchtung wieder zugeschaltet und in Stufe 5 wird bei einer Temperatur über 60 Grad Celsius das gesamte System notabgeschaltet und nach Temperaturabsenkung unter 60 Grad Celsius wieder angeschaltet, wobei ein Reboot erfolgt, die CMS automatisch gestartet und die Netzwerkverbindung wieder hergestellt wird.
